# EUROPEAN PATENT APPLICATION

(11) **EP 1 137 173 A1**
(43) Date of publication of application: **26.09.2001**
(21) Application number: 00830170.7
(22) Date of filing: 06.03.2000
(51) Int. Cl.: H03G 3/30

(54) **RF- FET bias and switching circuit based on a quasi-open loop regulation**

(71) Applicant: TELEFONAKTIEBOLAGET LM ERICSSON, 126 25 Stockholm (SE)
(72) Inventor: Mariotti, Marco, 15063 Cassano Spinola (AC) (IT)
(74) Representative: Vatti, Paolo, Dr. Ing.

(57) **Abstract**

An RF-FET bias and fast and controlled switching circuit, apt to ensure a good receiving of all signals from all users sharing the same access network. The circuit is software controlled and uses an open loop regulation for fast transitions and a closed loop adjusting for control of output power and thermal compensations.

## Description

Modern microwave TDMA (Time Division Multiple Access) Systems are required to have very fast and controlled switching of the radio frequency (RF) transmitter, in order to ensure the receiving of all signals from all of the users sharing the same access network, with only a minimum of reciprocal interference. Namely, a very fast switching (of the order of 100 ns) of transmitted output power and the control of the broadening of output spectrum are needed, so as to fulfil the international standard and to have a very good isolation from On to Off state.

To fulfil the requirement of spectrum mask during the On/Off transition, it is necessary to perform a pulse shaping of the On/Off pulse: this function is very critical to be done with a traditional closed loop bias circuit in the RF FET's, due to stability problems.

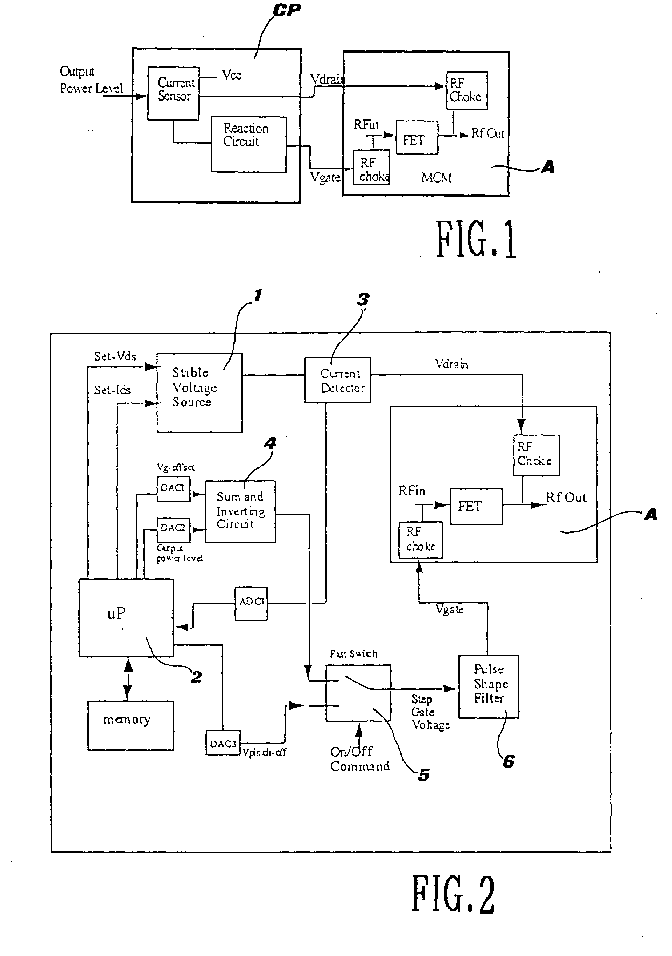

The present invention aims at playing the critical function of switching the power amplifier of a radio frequency transmitter by means of a new circuit which is able to bias RF-FET's contained inside a transmitter and of obtaining a controlled switching of the transmitted output power, without increasing the complexity of the RF-side of the transmitter itself. Consider, now, block diagram of a traditional bias circuit CP, based on a closed loop, as the one reported in the Fig. 1 of annexed drawings. Like it is well known, a circuit like this allows one to control current flowing in FET's of the amplifier A of a radio frequency transmitter by means of a closed loop regulation, acting on the gate voltage. The drawback of this solution during fast switching is that the circuit can be very delicate and dependent on the particular FET. Another risk is the possibility of oscillations due to the fact that the RF input (gate) and RF output (drain) are connected by the regulator circuit; the loop gain can be high, because of the poor possibility of filtering (to reach high switching speed), so that it is always possible that a particular FET, with a particular loop, reaches the oscillation condition at a certain frequency.

The drawbacks above are totally removed by the circuit according to the present invention, which makes the very fast output power changes not intervene on the normal system adjusting, so that they do not affect its stability, while the slowest changes (like the ones due to temperature or to other regulation) may still be managed as usually.

The invention solves the above problem by means of a software controlled regulation, which is based on a quasi-open loop, because it manages the first changes with an open loop and the second ones with a closed loop. Thus, the present invention more deeply refers to a RF-FET bias and fast and controlled switching circuit for RF transmitters, which is apt to ensure a good receiving of all signals from all of the users sharing the same access network, characterised in that it is software controlled, by using an open loop regulation for fast transitions and a closed loop regulation to control output power and thermal compensations. The said circuit comprises a stable voltage source, as well as a microprocessor carrying out a reading of the current in the amplifier of the RF transmitter by means of a current sensor, in order to change the gate voltage until the desired value of current is got, and a sum and inversion device, in order to control dynamics of output power by means of the said microprocessor, whereby the fast transitions are made by a fast switching hardware circuit, which operates as a by-pass, in order to let gate voltage change from the present value, corresponding to a defined output power, to the pinch-off value, interrupting the transmitter operation.

Furthermore, the RF-FET bias and controlled switching according to the invention preferably includes a pulse shaping filter, in order to fulfil the required spectral requirements, and it can also suitably include a supplementary circuit, by which the output power with respect to temperature is controlled, by measuring the present value of output power by means of a RF-detector and comparing the same to a reference level of power by means of the said microprocessor.

The invention is now explained more in depth, referring by mere way of example to a preferred embodiment thereof, illustrated in the annexed drawings, wherein:
Fig. 1 is a block diagram of a traditional closed loop, bias circuit, how it has already been discussed above;
Fig. 2 is a block diagram of the new bias and switching circuit according to the present invention;
Fig. 3 is the diagram of a possible supplementary circuit, suitable to control output power; and
Fig. 4 is a flow chart, illustrating the automatic calibration procedure in the inventive circuit.

The solution proposed by the present invention aims at providing the amplifier of RF transmitters with a stable drain voltage and with a gate voltage which is so controlled that the amplifier outputs the desired current stably (with no oscillations). In order to achieve this object, as it has been already said, the present invention provides a quasi open loop regulation, which is software controlled by means of a microprocessor. Referring now to Fig. 2 of the annexed drawings, the new quasi-open loop bias and switching circuit according to the invention includes a stable voltage source 1, as well as a microprocessor 2 which carries out a reading of current in the amplifier A by means of a current sensor 3, and it can then change gate voltage, until it gets the desired current value. On the other end, in order to control the dynamics of output power by means of the microprocessor 2, the inventive circuit includes also a sum and inversion circuit 4.

Fast transitions in the circuit according to the present invention are performed - see Fig. 2 - by means of a fast switching circuit 5: it is a hardware circuit which operates as a by-pass, in order to switch from the present value of gate voltage, corresponding to a given output power, to the gate voltage at which the transmitter operation is interrupted (pinch-off voltage). Finally, the inventive circuit in Fig. 2 includes a pulse shaping filter 6, apt to match with the required spectral requirements.

Let us consider the features of each component of the inventive circuit more in depth. It is to specify that the stable voltage source 1 has the purpose to feed a stable drain voltage and to eliminate possible noises by filtering.

Microprocessor 2, as it has already been mentioned, controls the whole operation of the inventive circuit, particularly by controlling gate voltage and output power. Furthermore, it automatically pre-calibrates upon start-up of the radio board and balances the temperature of each FET.

The current sensor 3 continuously provides a reading of the present current in every working condition. Such a current reading is used, as it has already been mentioned, by microprocessor 2 in order to establish the correct gate voltage of the amplifier A. Furthermore, sensor 3 can provide suggestions for possible alarms and is suitable to match the drain current to gate voltages to be fed to FET's co-operating with the microprocessor 2, so as to pre-calibrate the FET.

A voltage source, to be used to control the gate voltage basing on an open loop, is provided by means of sum and inversion circuit 4. Current flowing in the FET depends on the particular gate voltage. This circuit possesses two inputs: the control of the output power and an offset gate voltage. The control of the level of output power is a signal apt to control the whole gain (and the output power) of the transmitter, by means of a control of current in FET devices; such a signal is the same in the whole transmitter chain. The offset gate voltage is the gate voltage, required by each FET to use its own nominal current at the highest output power. Such a parameter depends on the particular device and is established during the FET pre-calibration by reading FET current (by means of the current sensor, when the command of output power equals zero and output power is the highest). The way to relate the nominal FET current to the gate voltage in an open loop connection lies in having a ramp of offset gate voltage, referred to its nominal value (with the signal of output power being zero) and in reading the current by means of the current sensor. When the read current is the nominal one, the offset voltage is stored and recalled every time the radio board operates. No instrument is required to pre-calibrate: this is in fact all inside the board. The control of output power may be effected by microprocessor 2, as per time constant of the regulation.

The fast switching circuit 5 is provided with a suitable device for high speed switching. The purpose of this component is to connect FET gate with both sum and inversion circuit, performing the normal regulation, and, alternatively, pinch off voltage of FET. Such a parameter is fixed for each device during pre-calibration, similarly to gate offset voltage, regulation being automatical also for this parameter.

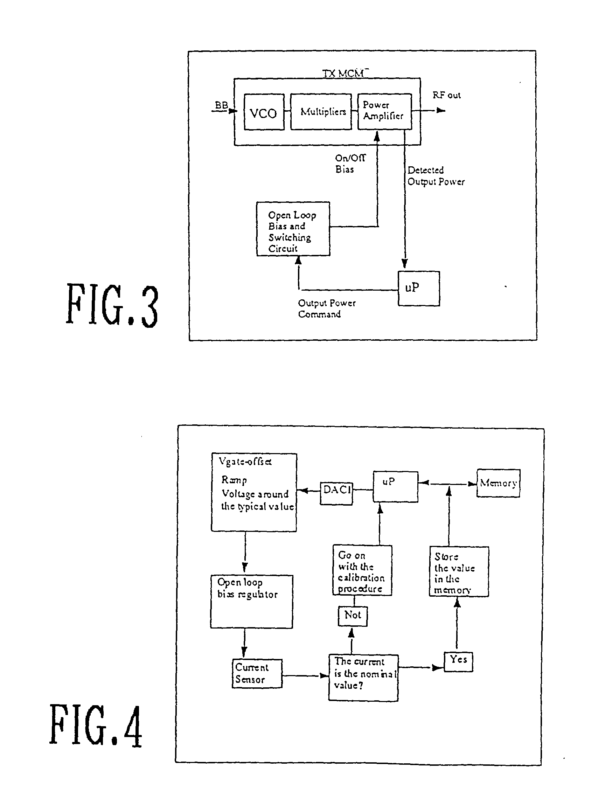

Pulse shaping filter 6 is an active filter provided with operational amplifiers. Its function is to shape the step command of the gate voltage received from the fast switch, so as to enable to control the shape of output power and the spectral broadening. Such a filter is de-coupled from its load (RF FET gate), so that the response is independent of the particular employed FET. The rise or fall time during the On/Off transition does not depend on the particular level of output power and also the delay in On/Off command to output power response is independent of the level of output power (the response in the fast switch circuit is always the same, independent of the particular input of sum and inversion block). Although the inventive device has been referred to as a quasi-open loop circuit, the above description seems to refer to a regulation based on a totally open loop. In fact, the loop is open as for the fast switching circuit, but it is anyway closed as for the control of output power and its thermal stability. In order to keep the level of output power constant with respect to temperature, output power can be measured by means of a RF detector and can be compared to a reference level by the microprocessor 6, such as clearly shown in Fig. 3. Time constant in the loop of RF output power due to the temperature is higher by about 10¹¹ than the time required for switching (100 ns). Even though an automatic control of the transmission power (ATPC) is contemplated in order to recover the changes in radio channel due to rain (about 100 dB/s), the time constant of the loop of RF output power is higher by about 10⁸ than the time require for switching (100ns).

As for the automatic calibration, microprocessor 2 should verify during the start-up of the radio board whether the calibration of RF-FET has already been performed. If not, microprocessor should attend to that and it should store the related parameters. No external instrument is required in order to perform the initialisation of FET parameters: indeed, all of the control parameters are internal and can be read directly by microprocessor 2. The procedure of automatic calibration is clearly summarised in the flow chart in Fig. 4.

Substantial advantages are obtained with the circuit according to the present invention with respect to the traditional closed loop solution.

First of all, performances independent of RF FET's (at certain minimum output power) are achieved. Thus, the open loop circuit does not depend on the particular FET and is poorly dependent on the layout of the radio board. This because the response of the filter is fixed, what does not happen in a traditional closed loop circuit, where the FET enters the loop, so that speed and stability depend also on the FET. The response of a traditional closed loop circuit depends on the loop gain, which in turn depends on the output power condition in order to avoid this problem, the circuit becomes very sensitive to assembling techniques and conditions, impairing the repetitively for quantity in a large scale production. This problem does not arise at all in the inventive circuit.

The circuit according to this invention provides, furthermore, a high stability. The open loop circuit is intrinsically more stable than a traditional closed loop circuit, because the RF input (gate) and RF output (drain) are no more connected through the bias circuit (they are "not visible"). It becomes more difficult to have low frequency oscillation, that the microwave capacitors of Amplifier A cannot filter.

Moreover, the circuit according to the invention avoid every problem connected to transients during On/Off transitions. When the FET is switched from Off to On, there is no transient problem due to the closed loop regulation: the gate regulation voltage does not change during the On/Off transition, so that there is no power overshoot or resonance around the nominal power value.

Finally, the open-loop bias circuit exhibits a high flexibility. Indeed, it can be easily configurated by the microprocessor to change the FET parameters (voltage and current). The calibration of each device enables to have performances almost independent of the particular employed FET (in the same family).

It is understood that other embodiments than the ones described of the present invention are possible. It is also understood that the circuit according to the invention can advantageously have applications other than the bias and fast and controlled switching in RF transmitters.

## Claims

1. RF-FET bias and fast and controlled switching circuit, apt to ensure a good receiving of all signals from all users sharing the same access network, **characterised in that** it is software controlled, by using an open loop regulation for fast transitions and a closed loop adjusting for control of output power and thermal compensations.

2. RF-FET bias and fast and controlled switching as claimed in claim 1, including a stable voltage source (1) and further including:
- a microprocessor (2), performing a reading of the current of amplifier (A) of the RF transmitter by means of a current sensor (3), in order to change the gate voltage until it gets the desired current value;
- a sum and inversion device (4), apt to control the dynamics of output power by means of the said microprocessor (2);
- fast transitions being performed by a fast switching hardware circuit (5), operating as a by-pass to switch the gate voltage from the present value, corresponding to a defined output power, to the pinch off value, with which the transmitter operation is interrupted.

3. RF-FET bias and fast and controlled switching as claimed in claims 1. and 2., further including a pulse shaping filter (6), apt to fulfil the required spectral requirements.

4. RF-FET bias and fast and controlled switching as claimed in claims 1. and 2., further comprising a supplementary circuit (Fig. 3) whereby the output power is controlled with respect to temperature by measuring the present value of the output power by means of a RF detector and by comparing it to a level of offset power by means of the said microprocessor (6).

5. Microwave communication system including an RF-FET bias and fast and controlled switching circuit, apt to ensure a good receiving of all signals from all users sharing the same access network, **characterised in that** it is software controlled, by using an open loop regulation for fast transitions and a closed loop adjusting for control of output power and thermal compensations.
